# FASCICULE DE BREVET EUROPEEN

(11) **EP 0 456 323 B1**
(45) Date de publication et mention de la délivrance du brevet: **14.08.1996**
(21) Numéro de dépôt: 91201076.6
(22) Date de dépôt: 06.05.1991
(51) Int. Cl.: G06K 19/077

(54) **Carte à microcircuit**
Karte mit Mikroschaltkreis
Microcircuit card

(30) Priorité: 11.05.1990 FR 9005917
(43) Date de publication de la demande: 13.11.1991
(73) Titulaire: PHILIPS CARTES ET SYSTEMES, 75013 Paris (FR); Philips Electronics N.V., 5621 BA Eindhoven (NL)
(72) Inventeur: Venambre, Jacques, F-75008 Paris (FR)
(74) Mandataire: Charpail, François

(56) Documents cités:
- EP-A- 0 163 880
- FR-A- 2 595 848
- FR-A- 2 617 668
- FR-A- 2 634 095
- GB-A- 2 100 669

## Description

La présente invention a pour objet une carte à microcircuit comportant un support de carte présentant un logement dans lequel est disposé le microcircuit, le support de carte présentant une région d'affaiblissement destinée à empêcher la transmission au microcircuit de contraintes de flexion.

Une telle carte est connue de l'antériorité EP 163880 (GAO Ges.), dans laquelle la région d'affaiblissement est disposée à l'extérieur du périmètre du logement où est disposé le microcircuit, et dans l'épaisseur totale de la carte. Cette solution convient en particulier au cas de cartes à trois couches laminées ensembles.

On connaît également de la demande de brevet français FR-A-2 617 668 déposée le 3/07/1987, des cartes dites "à vignette". La détention et l'utilisation de ces cartes impliquant des contraintes mécaniques appliquées au support de carte, lequel est souple ou semi-souple, lesquelles sont retransmises à la vignette et au circuit qu'elle porte.

La fiabilité des cartes à microcircuit de tous types est en relation directe avec leur capacité à résister à l'application répétée de telles contraintes sans effet néfaste sur ses propriétés électriques (connexions, intégrité du circuit).

C'est ainsi que des tests de résistance mécanique ont été définis selon lesquels une carte à microcircuit devrait nominalement être susceptible de supporter un (ou même plusieurs) milliers de flexions normalisées longitudinales ou transversales sans détérioration. Lors de telles flexions, et surtout lors de flexions induites en appliquant des forces parallèles à une direction longitudinale de la carte, le circuit est soumis à des contraintes élevées.

La présente invention propose d'améliorer les conditions mécaniques relatives aux retransmissions de contraintes au microcircuit en particulier lors de déformations mécaniques de la carte, et donc d'augmenter la fiabilité de la carte.

Dans ce but, le support de carte présente au moins deux zones d'affaiblissement constituant des joints élastiquement déformables situés entre d'une part un pilier du support de carte formant une partie d'un fond du logement située en face du microcircuit et d'autre part le reste dudit fond.

De telles zones d'affaiblissement constituent, ainsi qu'il sera montré dans la suite de la description, un piège de déformations et la partie du fond du logement, qui est située en regard du circuit constitue un pilier, l'ensemble permettant de diminuer les contraintes auxquelles est soumis le circuit. Les zones d'affaiblissement sont situées dans le fond du support de carte, et donc, contrairement au cas de l'antériorité EP 163880 précitée, à l'intérieur du périmètre du logement, dans une région qui a déjà une épaisseur réduite par rapport à l'épaisseur totale de la carte. Ainsi qu'il sera montré dans la suite de la description, ces zones d'affaiblissement permettent localement au pilier ainsi découplé mécaniquement du reste du fond de rester substantiellement plan, ce qui évite au moins dans une large mesure de soumettre le microcircuit à des contraintes de flexion.

Selon un mode de réalisation les zones d'affaiblissement s'étendent dans une direction longitudinale de la carte à partir de ladite partie du fond du logement. Ceci permet une amélioration en cas d'application de contraintes dans le sens longitudinal de la carte.

Les deux zones d'affaiblissement peuvent avantageusement être disposées de part et d'autre du pilier. On a ainsi une symétrie, le circuit étant en général disposé dans une partie centrale du logement.

Ladite zone d'affaiblissement peut être délimitée par une rainure, qui peut déboucher dans le logement. Un mode de réalisation préféré correspond à au moins une rainure débouchant dans le logement au moins un fil de connexion du circuit étant disposé au moins partiellement dans une dite rainure.

Une carte électronique selon l'invention peut être du type où une piste magnétique chevauche au moins partiellement ledit logement. Lors d'une lecture et/ou écriture d'une telle carte, le pilier permet d'éviter que les déformations mécaniques du fond ne soient trop importantes et le contact entre la tête et la piste est suffisant pour éviter un affaiblissement excessif du signal au niveau du logement ("drop out"). Par exemple lors qu'un galet vient rouler sur la vignette, ses déformations ne sont transmises au pilier qu'au delà d'un certain seuil.

Une couche résiliente formant entretoise peut être disposée entre le circuit et ladite partie du fond du logement. Un tel couplage contribue à diminuer les déformations mécaniques et à diminuer sensiblement la transmission des contraintes, particulièrement en dynamique.

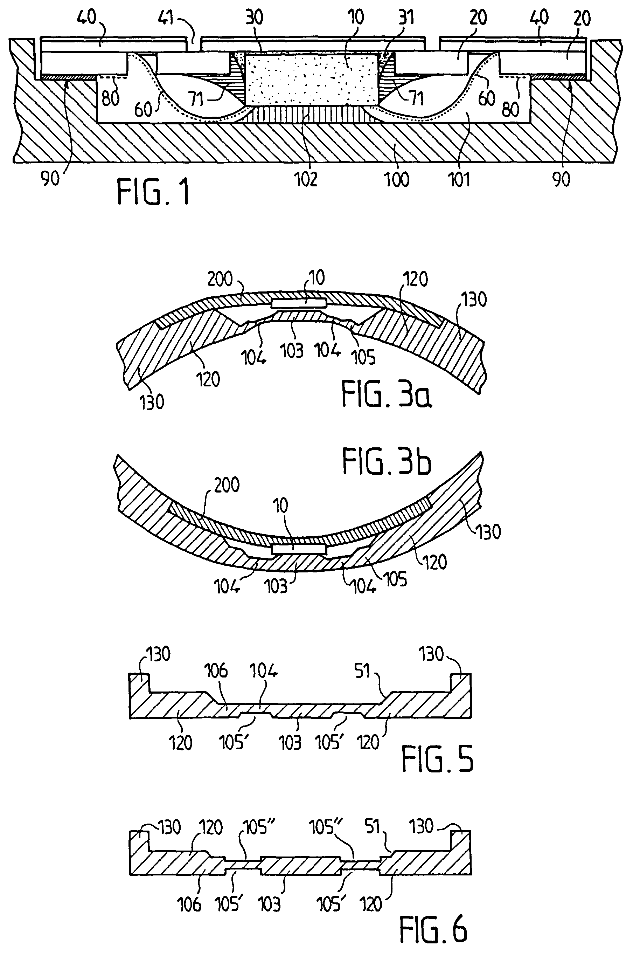

L'invention sera mieux comprise à la lecture de la description qui va suivre, donnée à titre d'exemple non limitatif, en liaison avec les dessins ci-annexés dans lesquels :- la figure 1 représente une carte électronique selon l'art antérieur précité,
- la figure 2a représente une coupe longitudinale d'une carte à microcircuit selon un mode préféré de réalisation de l'invention, la figure 2b étant un détail de la figure 2a, et la figure 2c le support de carte de la figure 2b,
- les figures 3a et 3b illustrent les phénomènes de déformation d'une carte selon l'invention,
- la figure 4a représente en vue de dessus un support de carte selon l'invention, éventuellement pourvu de piste de pistes magnétiques chevauchant le logement, et la figure 4b une vue agrandie du logement de la carte de la figure 4a,
- et les figures 5 et 6 représentent des variantes de l'invention.

Selon la figure 1, une carte à microcircuit comporte une vignette 200, présentant un support de circuit (20, 40) et un circuit 10,et fixée dans un logement 101, le circuit 10 étant disposé sur une face inférieure du support de circuit (20, 40) de telle sorte que le circuit 10 est disposé à l'intérieur du logement 101 et fait face au fond 100 du logement 101. Le circuit 10 est collé de manière classique par une colle conductrice (30, 31) sur le support de circuit (20, 40) et des fils de connexion 60 sont soudés entre le circuit 10 et le support de circuit (20, 40), lequel présente des couches conductrices disposées de manière à réaliser les connexions nécessaires. Le support de circuit présente ici une couche conductrice 40 en l'espèce une feuille de cuivre sur laquelle ont été déposées électrolytiquement une couche de Ni, puis une couche d'Au, et une couche isolante 20, l'ensemble formant un support souple. La couche 40 présente des ouvertures 41 le séparant électriquement en différentes zones permettant d'isoler les prises de contact électrique. Des fils de connexion 60 sont mis en place par ultra-sons entre la face supérieure de la pastille 10 et lesdites zones. Des zones 71 en résine époxy présentant un profil progressif peuvent être disposées pour renforcer la tenue mécanique. On trouvera une description plus détaillée de cette mise en oeuvre dans la demande de brevet français FR 2 580 416 déposée le 12/04/1985.

La vignette, obtenue après découpe, est retournée et collée en 90 dans le logement 101. En 90, un adhésif double face pelable peut être mis en oeuvre selon la demande de brevet FR 2 580 416 précitée, la couche pelable pouvant servir de masque à un vernis de protection 80.

Enfin, un collage en 102 est réalisé par une couche de résine polyuréthane, relativement dure, de manière à obtenir une bonne rigidité mécanique de l'ensemble. Une telle résine est par exemple le DAMIVAL 13521 fabriquée par ALSTHOM présentant une dureté nominale de 85 SHORE D2 après polymérisation. Les résines de la famille DAMIVAL sont considérées par le fabricant comme rigides pour une dureté de 90 SHORE D2, semi-rigide pour une dureté de 85 SHORE D2 (comme ci-dessus), et souples pour une dureté 50 SHORE D2.

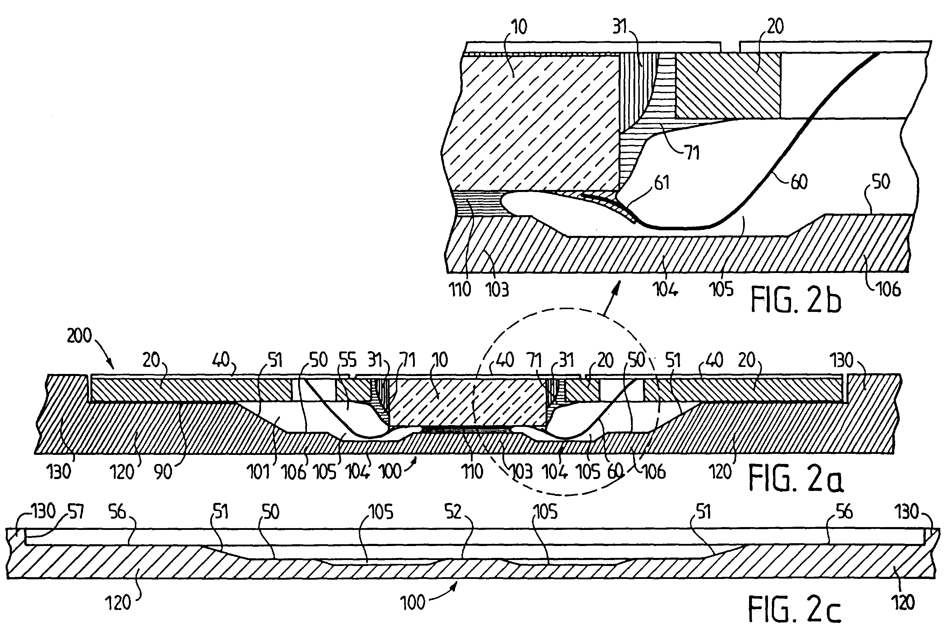

Selon les figures 2a, 2b et 2c, la face interne 50 du fond 100 du logement 101 d'un support de carte 130 est rainuré en 105, ici selon deux rainures situées en majeure partie de part et d'autre du circuit 10 et définissant deux régions amincies 104 constituant des régions d'affaiblissement faisant fonction de joints élastiquement déformables, laissant subsister une partie 103 plus épaisse faisant face à une majeure partie du circuit 10.

On notera un chanfrein 51 entre le fond 56 de l'embrèvement de contour extérieur 57 où le collage 90 de la vignette 200 est réalisée et le logement 101 proprement dit. Un chanfrein 51 délimite l'extérieur du logement 101 et forme une transition entre une partie externe 106 du fond 100 et la région 120 du support de carte 130 où est réalisé l'embrêvement. Une couche résiliente 110 peut être disposée entre le circuit 10 et la face interne 51 de la partie centrale 103 du fond 100 du logement 101. Sa fonction sera explicitée par la suite. On remarquera également que l'on a mis à profit la présence des rainures 105 pour absorber au moins en partie la surépaisseur des fils 60 par rapport au circuit 10 au voisinage de la soudure fil en 61 sur la face principale du circuit 10 tournée vers le fond 100. Ceci permet un gain de place non négligeable. De fait, la partie centrale 103 est plus étroite que la portion du fond 100 qui fait face au circuit 10 (et donc que le circuit 10) pour laisser un dégagement au fil 60 au voisinage de la soudure fil 61.

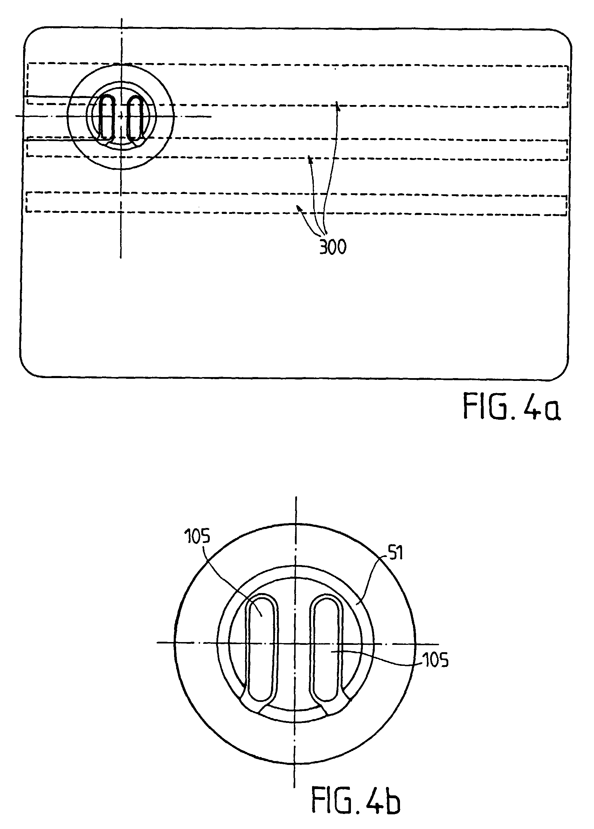

Les figures 4a et 4b montrent en vue de dessus une réalisation des rainures 105 qui est obtenue par fraisage. Plus particulièrement, des pistes magnétiques éventuelles 300 disposées sur la face arrière de la carte peuvent chevaucher le logement 101, ce qui fait qu'un dispositif de lecture/écriture magnétique induit une contrainte sur la vignette et/ou le fond 100 de logement lors d'une lecture et/ou d'une écriture de la carte.

Les figures 5 et 6 montrent enfin deux variantes de réalisation de l'invention. Des rainures 105' peuvent être disposées sur la face du support de carte opposée au logement 101 (fig.5), ou bien des rainures 105' et 105'' peuvent être disposées simultanément sur la face interne du logement 101 et sur la face du support de carte opposée au logement 101 (fig.6).

En se reportant plus particulièrement aux figures 3a et 3b, on va maintenant expliquer l'influence des parties amincies 104 lors d'une flexion de la carte.

Selon la figure 3a, la vignette 200 est en extension, et la face interne 52 du fond 50 tend à être plaquée contre le circuit 10. Les parties amincies 104 plient et absorbent ainsi une grande partie des déformations, ce qui fait que la partie 103, soit n'appuie pas contre le circuit, soit pour une flexion plus importante de la carte, appuie contre le circuit 10 en ne retransmettant à celui-ci qu'une partie seulement des contraintes du fait qu'elle reste substantiellement plane, ce qui a pour effet d'augmenter la fiabilité de la carte lors de flexions répétées. Dans le cas de la fig.3a, la fonction des parties amincies 104 est de servir de piège de déformations pour éviter que la partie centrale 103 ne retransmette des contraintes trop élevées au circuit 10.

En effet, s'il était soumis à une flexion subtantielle, le fond du logement porterait contre la carte sur une surface réduite d'ou une concentration des contraintes, et une contrainte résultante élevée sur le microcircuit.

Selon la figure 3b, la vignette 200 est en compression et le circuit 10 vient s'appuyer contre la partie centrale 103 formant un pilier (ou un poutre), qui se déplace par translation grâce aux parties amincies 104 tout en restant substantiellement plane. De ce fait, les contraintes subies par le circuit 10 sont diminuées, tout en maintenant les déformations du fond 50 du logement 101 dans des limites raisonnables. Le fonctionnement en pilier de la partie 103 permet en particulier une plus grande surface de contact entre celle-ci et le circuit 10, car les déformations sont subies essentiellement par les parties amincies 104, et la partie 103 reste relativement plane, d'où comme précédemment un minimum de contraintes sur le microcircuit. En pratique, on donnera à la partie centrale 103 l'épaisseur maximale compatible avec les tolérances sur l'épaisseur de la carte et une surface égale à celle du circuit 10, sauf passage éventuel des fils 60. On aura tout intérêt à réaliser les parties amincies 104 avec la largeur la plus grande et l'épaisseur la plus faible compatible avec des tests de flexions répétées.

Exemple : Une carte bancaire en chlorure de polyvinyle (PVC) chargé de TᵢO₂ selon le standard ISO de longueur nominale 85,6mm et de largeur nominale 53,98mm et d'épaisseur nominale 810 microns présente un logement de diamètre total 57 environ 16,2mm, le diamètre au bord du chanfrein 51 étant de 12mm. Le fond 50 du logement 101 présente une épaisseur de 300 microns, les parties amincies 104 présentant une épaisseur de 200 microns, une longueur de 6,9mm et une largeur de 2,5mm, le pilier 103 ayant une largeur de 2,5mm. Il existe une tolérance nominale de 50 microns entre le circuit 10 et la partie centrale 103.

La couche résiliente 110, éventuellement présente, peut être réalisée en silicone RTV3140 fabriquée par DOW CORNING et présentant une dureté de 20 à 30 SHORE D2 suivant les conditions, notamment hygrométriques, de vulcanisation. En conservant les critères d'évaluation utilisés ci-dessus pour les résines, on pourrait qualifier le RTV3140 de "très souple". Elle permet d'obtenir un amortissement dynamique des contraintes transmises entre la carte 10 et la partie centrale 103 du fond 50, venant ainsi apporter un complément à l'effet des parties amincies 104. La couche résiliente 110 ne doit pas être trop déformable de manière à remplir sa fonction d'amortissement, mais suffisamment déformable de manière à éviter une rigidification de l'ensemble qui serait favorable à la transmission de contraintes au microcircuit. Ce sont les tests en flexion qui permettent de déterminer la résilience optimale de la couche 110.

Une carte selon l'invention, mais de préférence avec une couche résiliente 110, présente de bonnes propriétés en cas de lecture magnétique de pistes magnétiques chevauchant partiellement le logement 101. Dans ce cas, la partie centrale 103 forme un pilier dont la rigidité permet d'éviter des déformations trop importantes entraînant des affaiblissements trop importants ("drop out") du signal. Comme il n'y a pas de souche rigide 102, les déformations de la vignettes induites éventuellement par un galet qui roule sur celle-ci lors d'une lecture-écriture mangétique ne sont retransmises au pilier 10 qu'au delà d'un certain seuil. Il est particulièrement recommandé de laisser la tolérance la plus faible possible entre le circuit 10 et la partie centrale 103 de manière que cette dernière soit ₁a plus épaisse possible et donc la plus rigide possible, ce qui est également favorable dans le cas de flexions ilustrées aux figures 3a et 3b.

L'invention ne se limite pas aux modes de réalisation décrits et représentés. Le circuit 10 n'est pas forcément disposé au centre du logement 101 qui peut avoir des formes autres que circulaires. Un logement 101 peut ne compter qu une seule partie amincie 103, en particulier dans le cas ou le circuit 10 jouxterait un bord du logement. Les rainures 105, 105' et 105'' pourraient être par exemple réalisées par moulage.

## Revendications

1. Carte à microcircuit comportant un support de carte présentant un logement dans lequel est disposé le microcircuit, le support de carte présentant une région d'affaiblissement destinée à empêcher la transmission au microcircuit de contraintes de flexion caractérisé en ce que le support de carte présente au moins deux zones d'affaiblissement (104) constituant des joints élastiquement déformables, situées entre d'une part un pilier (103) du support de carte formant partie d'un fond (100) du logement située en face du microcircuit et d'autre part le reste dudit fond (100).

2. Carte à microcircuit selon la revendication 1, caractérisée en ce que ladite zone d'affaiblissement (104) s'étend dans une direction longitudinale de la carte à partir de ladite portion de fond (100) du logement (101).

3. Carte à microcircuit selon une des revendications 1 ou 2 caractérisée en ce qu'elle comporte deux zones d'affaiblissement (104) disposées de part et d'autre dudit pilier (103).

4. Carte à microcircuit selon une des revendications précédentes caractérisée en ce qu'une dite zone d'affaiblissement est délimitée par une rainure (105).

5. Carte à microcircuit selon la revendication 4 caractérisée en ce que ladite rainure (105) débouche dans le logement (101).

6. Carte à microcircuit selon la revendication 5, caractérisée en ce qu'au moins un fil de connexion (60) dudit circuit est disposé au moins partiellement dans une dite rainure (105).

7. Carte à microcircuit selon une des revendications 5 ou 6 caractérisée en ce qu'elle comporte au moins une piste magnétique (300) chevauchant au moins partiellement ledit logement(101).

8. Carte à microcircuit selon une des revendications précédentes caractérisée en ce qu'elle comporte une couche résiliente (110) formant entretoise entre le circuit (10) et ledit pilier (103).

9. Carte à microcircuit selon la revendication 8 caractérisée en ce que la couche résiliente (110) a une dureté comprise entre 20 et 30 SHORE D2.

10. Support de carte présentant un logement destiné à recevoir un microcircuit, ledit logement présentant un fond, caractérisé en ce que ledit fond (100)présente au moins deux zones d'affaiblissement (104) constituant des joints élastiquement déformables et disposés en dehors d'un pilier (103) central dudit fond (100).

## Patentansprüche

1. Eine Karte mit einer Mikroschaltung bestehend aus einem Kartenträger mit einer Aussparung, in der die Mikroschaltung eingefügt wird, der Kartenträger weist einen Dämpfungsbereich auf, um die Übertragung von Biegespannungen an die Mikroschaltung zu verhindern, mit dem Merkmal, daß der Kartenträger mindestens zwei Dämpfungszonen (104) aufweist, die sich einerseits zwischen einem Pfeiler (103) des Kartenträgers, der einen Teil des Bodens (100) einer Einfügung gegenüber der Mikroschaltung bildet, und andererseits zwischen dem restlichen Teil dieses Bodens (100) befindet.

2. Eine Karte mit einer Mikroschaltung laut Anspruch 1, mit dem Merkmal, daß sich die besagte Dämpfungszone (104) sich von dem besagten Teil des Bodens (100) der Einfügung (101) in Längsrichtung der Karte erstreckt.

3. Eine Karte mit einer Mikroschaltung laut Anspruch 1 oder 2, mit dem Merkmal, daß sie zwei Dämpfungszonen (104) aufweist, auf der einen und anderen Seite des Pfeilers (103) vorgesehen.

4. Eine Karte mit einer Mikroschaltung laut einem der vorhergehenden Ansprüche, mit dem Merkmal, daß eine besagte Dämpfungszone mit einer Rille (105) begrenzt ist.

5. Eine Karte mit einer Mikroschaltung laut Anspruch 4, mit dem Merkmal, daß die besagte Rille (105) in die Einfügung (101) führt.

6. Eine Karte mit einer Mikroschaltung laut Anspruch 5, mit dem Merkmal, daß mindestens eine Verbindungsleitung (60) zumindest teilweise in die besagte Rille (105) eingebracht ist.

7. Eine Karte mit einer Mikroschaltung laut einem der Ansprüche 5 oder 6, mit dem Merkmal, daß sie mindestens einen Magnetstreifen (300) aufweist, der zumindest teilweise die besagte Einfügung (101) überschneidet.

8. Eine Karte mit einer Mikroschaltung laut einem der vorhergehenden Ansprüche, mit dem Merkmal, daß sie eine elastische Schicht (110) aufweist, die eine Versteifung zwischen der Schaltung (10) und dem besagten Pfeiler (103) bildet.

9. Eine Karte mit einer Mikroschaltung laut Anspruch 8, mit dem Merkmal, daß die Versteifungsschicht (110) eine Härte zwischen 20 und 30 SHORE D2 aufweist.

10. Ein Kartenträger mit einer Aussparung für die Aufnahme einer Mikroschaltung, die besagte Aussparung weist einen Boden auf, mit dem Merkmal, daß der besagte Boden (100) mindestens zwei Dämpfungszonen (104) aufweist, die elastisch verformbare Verbindungen bilden und außerhalb eines mittleren Pfeilers (103) des besagten Bodens (100) vorgesehen sind.

## Claims

1. A microcircuit card comprising a card support which has a cavity in which the microcircuit is arranged and which has a thinned region which is to prevent the transmission of bending stresses to the microcircuit, characterized in that the card support comprises at least two thinned zones (104) which constitute elastically deformable joints situated between on the one hand a support platform (103) forming a portion of a bottom (100) of the cavity situated opposite the microcircuit and on the other hand the remainder of said bottom (100).

2. A microcircuit card as claimed in Claim 1, characterized in that said thinned zone (104) extend in a longitudinal direction of the card away from said portion of the bottom (100) of the cavity (101).

3. A microcircuit card as claimed in Claim 1 or 2, characterized in that it comprises two thinned zones (104) disposed on either side of said support platform (103).

4. A microcircuit card as claimed in any one of the preceding Claims, characterized in that one said thinned zone is bounded by a groove (105).

5. A microcircuit card as claimed in Claim 4, characterized in that said groove (105) issues into the cavity (101).

6. A microcircuit card as claimed in Claim 5, characterized in that at least one connection wire (60) of said circuit is arranged at least partly in a groove (105).

7. A microcircuit card as claimed in Claim 5 or 6, characterized in that it comprises at least one magnetic strip (300) which overlaps said cavity (101) at least partly.

8. A microcircuit card as claimed in any one of the preceding Claims, characterized in that it comprises a resilient layer (110) which forms a spacer between the circuit (10) and said support platform (103).

9. A microcircuit card as claimed in Claim 8, characterized in that the resilient layer (110) has a hardness which lies between 20 and 30 SHORE D2.

10. A card support having a cavity which is to receive a microcircuit, which cavity has a bottom, characterized in that said bottom (100) has at least two thinned zones (104) which constitute elastically deformable joints and which are arranged outside a support platform (103) of said bottom (100).
